(19) Europäisches Patentamt
European Patent Office
Office européen des brevets

(11) Veröffentlichungsnummer: **0 260 534 B1**

(12) **EUROPÄISCHE PATENTSCHRIFT**

(45) Veröffentlichungstag der Patentschrift: **18.12.91**

(51) Int. Cl.⁵: **C23C 16/18**, C07F 5/00, H01L 21/205

(21) Anmeldenummer: **87112843.5**

(22) Anmeldetag: **03.09.87**

# (54) Metallorganische Verbindungen.

(30) Priorität: **16.09.86 DE 3631469**

(43) Veröffentlichungstag der Anmeldung:
**23.03.88 Patentblatt 88/12**

(45) Bekanntmachung des Hinweises auf die Patenterteilung:
**18.12.91 Patentblatt 91/51**

(84) Benannte Vertragsstaaten:
**BE DE FR GB NL**

(56) Entgegenhaltungen:
**EP-A- 0 073 417**
**EP-A- 0 108 469**
**US-A- 4 509 997**
**EP-A- 0 080 349**
**US-A- 4 171 235**
**US-A- 4 588 451**

(73) Patentinhaber: **MERCK PATENT GESELLSCHAFT MIT BESCHRÄNKTER HAFTUNG**
**Frankfurter Strasse 250 Postfach 4119**
**W-6100 Darmstadt(DE)**

(72) Erfinder: **Erdmann, Dietrich, Dr.**
**Heideweg 4**
**W-6109 Mühltal(DE)**
Erfinder: **Van Ghemen, Max Emanuel, Dr.**
**Alfred-Messel-Weg 12**
**W-6100 Darmstadt(DE)**
Erfinder: **Pohl, Ludwig, Dr.**
**Niebergallweg 5**
**W-6100 Darmstadt(DE)**
Erfinder: **Schumann, Herbert, Prof. Dr.**
**Weberstrasse 3**
**W-1000 Berlin 49(DE)**
Erfinder: **Hartmann, Uwe**
**Alt-Tegel 33**
**W-1000 Berlin 20(DE)**
Erfinder: **Wassermann, Wilfried**
**Krumme Strasse 25**
**W-1000 Berlin 12(DE)**
Erfinder: **Heyen, Meino, Dr.**
**Schurzelter Mühle 61**
**W-5100 Aachen(DE)**
Erfinder: **Jürgensen, Holger, Dr.**
**Melatener Strasse 56**
**W-5100 Aachen(DE)**

**EP 0 260 534 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft die Verwendung von metallorganischen Verbindungen, die Aluminium, Gallium oder Indium als Metalle enthalten, für die Herstellung dünner Filme oder epitaktischer Schichten durch Gasphasenabscheidung.

Die Abscheidung solcher Schichten aus entweder reinen Elementen der III. Gruppe oder aus Kombinationen mit anderen Elementen wie z.B. Galliumarsenid, Indiumphosphid oder Galliumphosphid, kann zur Herstellung von elektronischen und optoelektronischen Schaltelementen, Verbindungshalbleitern und Lasern verwendet werden. Die Abscheidung dieser Schichten erfolgt aus der Gasphase.

Die Eigenschaften dieser Filme hängen von den Abscheidungsbedingungen und der chemischen Zusammensetzung des abgeschiedenen Films ab.

Für die Abscheidung aus der Gasphase kommen alle bekannten Methoden wie die Metal-Organic Chemical Vapour Deposition Methode (MOCVD), die Photo-Metal-Organic Vapour Phase Methode (Photo-MOVP), bei welcher die Substanzen durch UV-Bestrahlung zersetzt werden, die Laser Chemical Vapour Deposition (Laser CVD) Methode oder die Metal-Organic Magnetron Sputtering Methode (MOMS) in Frage. Die Vorteile gegenüber anderen Methoden sind ein kontrollierbares Schichtenwachstum, eine genaue Dotierungskon trolle sowie eine aufgrund der Normal- oder Niederdruckbedingungen einfache Handhabung und Produktionsfreundlichkeit.

Bei der MOCVD-Methode werden metallorganische Verbindungen eingesetzt, die sich unter Abscheidung des Metalls bei einer Temperatur unterhalb 1100 °C zersetzen. Typische Apparaturen, die zur Zeit für MOCVD benutzt werden, bestehen aus einem "bubbler" mit einer Zufuhr für die metallorganische Komponente, einer Reaktionskammer, die das zu beschichtende Substrat enthält sowie einer Quelle für ein Trägergas, das gegen die metallorganische Komponente inert sein soll. Der "bubbler" wird auf einer konstanten, relativ niedrigen Temperatur gehalten, die vorzugsweise über dem Schmelzpunkt der metallorganischen Verbindung, aber weit unterhalb der Zersetzungstemperatur liegt. Die Reaktions- oder Zersetzungskammer hat vorzugsweise eine sehr viel höhere Temperatur, die unterhalb 1100 °C liegt, bei welcher die metallorganische Verbindung sich vollständig zersetzt, und das Metall abgeschieden wird. Durch das Trägergas wird die metallorganische Verbindung in den Dampfzustand gebracht und mit dem Trägergas in die Zersetzungskammer geschleust. Der Massenfluß des Dampfes ist gut zu kontrollieren und somit ist auch ein kontrolliertes Wachsen der dünnen Schichten möglich.

Bislang wurden für die Gasphasenabscheidung hauptsächlich Metallalkyle wie z.B. Trimethylgallium, Trimethylaluminium oder Trimethylindium verwendet. Diese Verbindungen sind jedoch extrem luftempfindlich, selbstentzündlich und teilweise bereits bei Raumtemperatur zersetzlich. Daher sind für die Herstellung, den Transport, die Lagerung und die Anwendung dieser Verbindungen aufwendige Vorsichtsmaßnahmen notwendig. Es sind auch einige, etwas stabilere Addukte der Metallalkyle mit Lewisbasen wie z.B. Trimethylamin und Triphenylphosphin bekannt (z.B. beschrieben in GB 21 23 422, EP-A 108469 oder EP-A 176537), die jedoch aufgrund des geringen Dampfdruckes nur bedingt für die Gasphasenabscheidung geeignet sind.

Aufgabe der vorliegenden Erfindung war es nun, Metallalkylverbindungen zu finden, die einfach handhabbar und bei Raumtemperatur stabil sind und die sich aus der Gasphase zersetzen lassen, also für die verschiedenen Methoden der Gasphasenabscheidung geeignet sind.

Es wurde nun gefunden, daß sich metallorganische Verbindungen von Aluminium, Gallium und Indium, die intramolekular stabilisiert sind, hervorragend für die Gasphasenabscheidung eignen.

Intramolekular stabilisierte Verbindungen dieser Art mit Aluminium als Metallatom sind z.B. in US 3154528 beschrieben, und zwar für d ie Verwendung als Katalysatorsysteme bei Polymerisationsreaktionen. Ferner ist in Organometallics 1982, 1, 1492-1495, ein Indiumderivat, 2-(Dimethylaminomethyl)phenyldimethylindium, beschrieben, welches zu Strukturuntersuchungen mittels Kernresonanzspektroskopie herangezogen wurde.

Gegenstand der Erfindung ist daher die Verwendung von metallorganischen Verbindungen der Formel I

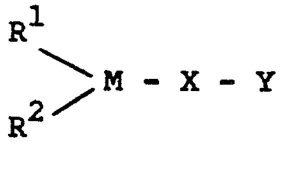

I

worin

| | |
|---|---|
| M | Aluminium, Indium, Gallium, |
| X | $-(CHR^5)_n-$ mit n = 2, 3, 4 oder 5, $-2-C_6H_4-(CH_2)_m-$, $-(CH_2)_m-2-C_6H_4-$, $-2-C_6H_{10}-(CH_2)_m-$, $-(CH_2)_m-2-C_6H_{10}-$ mit m = 1 oder 2, |
| $R^5$ | jeweils H oder eine Alkylgruppe mit 1-4 C-Atomen, |
| Y | ein 5- oder 6-gliedriger heterocyclischer Ring, wobei das (die) Heteroatom(e) aus der 5. Hauptgruppe stammen oder $-NR^3R^4$, $-PR^3R^4$, $-AsR^3R^4$, $-SbR^3R^4$, und |
| $R^1$, $R^2$, $R^3$, $R^4$ | jeweils unabhängig voneinander H, eine geradkettige oder verzweigte Alkylgruppe mit 1-8 C-Atomen, die teilweise oder vollständig fluoriert sein kann, eine Cycloalkyl-, Alkenyl-oder Cycloalkenylgruppe mit jeweils 3-8 C-Atomen oder eine unsubstituierte oder substituierte Phenylgruppe bedeuten, |

zur Gasphasenabscheidung sowie ein Verfahren zur Herstellung dünner Filme oder epitaktischer Schichten durch Gasphasenabscheidung des Metalls aus metallorganischen Verbindungen, bei dem als metallorganische Verbindungen die Verbindungen der Formel I eingesetzt werden. Ferner ist Gegenstand der Erfindung, daß man bei dem erfindungsgemäßen Verfahren zur Herstellung von Verbindungshalbleitern während des Abscheidungsprozesses eine oder mehrere unter den angewandten Reaktionsbedingungen gasförmige Verbindungen des Arsens, Antimons oder Phosphors zuführt.

In Formel I bedeutet M vorzugsweise Indium oder Gallium. X bedeutet $-(CHR^5)_n-$ mit n gleich 2, 3, 4 oder 5, vorzugsweise ist n gleich 3 oder 4. $R^5$ stellt entweder ein H-Atom oder eine Methyl-, Ethyl-, Propyl- oder Butylgruppe dar. Vorzugsweise ist $R^5$ H. Falls $R^5$ eine Alkylgruppe ist, so ist vorzugsweise nur ein $R^5$ in $-(CHR^5)_n$-Alkyl, die anderen bedeuten dann H.

Weiter kann X eine $-2-C_6H_4-(CH_2)_m-$ oder eine $-2-C_6H_{10}-(CH_2)_m$-Gruppe bedeuten, ferner auch eine $-(CH_2)_m-2-C_6H_4-$ oder $-(CH_2)_m-2-C_6H_{10}$-Gruppe. m ist dabei bevorzugt 1.

Y in Formel I bedeutet vorzugsweise $-NR^3R^4$, aber auch $-PR^3R^4$, $-AsR^3R^4$ oder $-SbR^3R^4$. Y kann auch ein 5- oder 6-gliedriger heterocyclischer Ring mit einem oder mehreren Atom(en) der 5. Hauptgruppe, wie N, P oder As, sein. Insbesondere sind folgende Ringe (1) bis (5) bevorzugt:

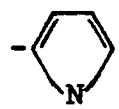

(1)

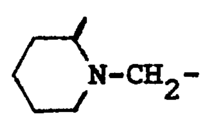

(2)

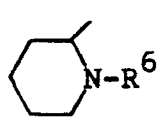

(3)

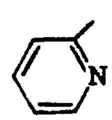

(4)

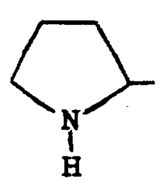

(5)

wobei $R^6$ H oder einen Alkylrest mit 1-8 C-Atomen bedeutet.

Die Reste $R^1$, $R^2$, $R^3$ und $R^4$ in Formel I können jeweils eine geradkettige oder verzweigte Alkylgruppe mit 1-8 C-Atomen bedeuten, bevorzugt mit 1-4 C-Atomen. Sie bedeuten demnach bevorzugt Methyl, Ethyl, Propyl, Butyl, iso-Propyl, sek.-Butyl, tert.-Butyl, aber auch Pentyl, Hexyl, Heptyl, Octyl, 2-Methylpentyl, 3-Methylpentyl oder 2-Octyl. Die Alkylreste können teilweise oder auch vollständig fluoriert sein und z.B. Monofluormethyl, Trifluormethyl, Difluorethyl, Trifluorethyl, Pentafluorethyl oder Trifluorpropyl bedeuten.

Falls $R^1$, $R^2$, $R^3$ und/oder $R^4$ eine Cycloalkyl- oder Cycloalkenylgruppe bedeuten, so stellen sie vorzugsweise Cyclopentyl, Cyclohexyl oder Cyclohexenyl dar. $R^1$ bis $R^4$ können auch Alkenylgruppen mit

3-8 C-Atomen sein, also Propenyl, Butenyl, Pentenyl, Hexenyl, Heptenyl oder Allyl. Falls $R^1$ und/oder $R^2$ und/oder $R^3$ und/oder $R^4$ eine Phenylgruppe bedeutet, so ist diese bevorzugt unsubstituiert, sie kann aber auch substituiert vorliegen. Da diese Substituenten keinen wesentlichen Einfluß auf den angestrebten Verwendungszweck ausüben, sind alle Substituenten erlaubt, die keinen störenden Einfluß auf die Zersetzungsreaktion haben.

Folgende Verbindungen sollen als beispielhafte Vertreter von Verbindungen der Formel I gelten:
(2-Dimethylaminobenzyl)dimethylindium
(3-Dimethylaminopropyl)dimethylaluminium
(3-Diethylaminopropyl)dimethylaluminium
(3-Diethylaminopropyl)diisobutylaluminium
(3-Diisopropylaminopropyl)dihexylaluminium
(4-N-Methyl-N-isopropylaminobutyl)diethylaluminium
[3-(1-Piperidyl)propyl]diethylaluminium
[2-(2-Pyridyl)ethyl]dimethylaluminium
[3-(2-Pyridyl)propyl]diisobutylaluminium.

Für die erfindungsgemäße Verwendung der Verbindungen der Formel I ist wesentlich die intramolekulare Stabilisierung, die auf einer Bindung zwischen dem Metallatom und dem jeweiligen Heteroatom der Gruppe Y, das durch 2, 3, 4 oder 5 C-Atome vom Metall getrennt ist, beruht. Durch diese intramolekulare Bindung erhalten die Verbindungen der Formel I im Vergleich zu den freien Metallalkylen eine bedeutend höhere Stabilität gegenüber Luft und Sauerstoff. Sie sind nicht mehr selbstentzündlich und daher einfach und ohne größere Vorsichtsmaßnahmen zu handhaben.

Die Verbindungen der Formel I sind z.T. bekannt, großenteils aber auch noch neu.

Neue Verbindungen sind insbesondere diejenigen der Formel II

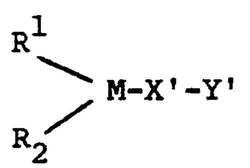

II

worin

| | |
|---|---|
| M | Aluminium, Indium, Gallium, |
| X' | $2\text{-}C_6H_4\text{-}(CH_2)_m\text{-}$, $\text{-}(CH_2)_m\text{-}2\text{-}C_6H_4\text{-}$, $2\text{-}C_6H_{10}\text{-}(CH_2)_m\text{-}$, $\text{-}(CH_2)_m\text{-}2\text{-}C_6H_{10}\text{-}$, mit m = 1 oder 2, |
| Y' | $\text{-}NR^3R^4$, $\text{-}PR^3R^4$, $\text{-}AsR^3R^4$, $\text{-}SbR^3R^4$ und |
| $R^1$, $R^2$, $R^3$, $R^4$ | jeweils unabhängig voneinander H, eine geradkettige oder verzweigte Alkylgruppe mit 1-8 C-Atomen, die teilweise oder vollständig fluoriert sein kann, eine Cycloalkyl-, Alkenyl-oder Cycloalkenyigruppe mit jeweils 3-8 C-Atomen oder eine unsubstituierte oder substituierte Phenylgruppe bedeuten, |

mit der Maßgabe, daß $R^1$, $R^2$, $R^3$ und $R^4$ nicht gleichzeitig Methyl bedeuten, falls M Indium, X' $\text{-}2\text{-}C_6H_4\text{-}CH_2\text{-}$ und Y' $\text{-}NR^3R^4$ bedeuten.

Dabei bedeutet M vorzugsweise Gallium oder Indium. X' ist vorzugsweise $\text{-}2\text{-}C_6H_4\text{-}CH_2\text{-}$, $\text{-}CH_2\text{-}2\text{-}C_6H_4\text{-}$ oder $\text{-}2\text{-}C_6H_{10}\text{-}CH_2\text{-}$. Y' hat bevorzugt die Bedeutung von $NR^9R^4$. $R^1$, $R^2$, $R^3$ und $R^4$ haben die für Formel I angegebenen Bedeutungen.

Die Verbindungen der Formel II umfassen beispielsweise folgende Substanzen:
2-Dimethylaminobenzyl(dimethyl)gallium
2-Dimethylaminobenzyl(dimethyl)aluminium
2-Diethylaminobenzyl(dimethyl)indium
2-Dimethylaminobenzyl(diethyl)indium
2-Diethylaminobenzyl(diethyl)gallium
2-Diethylaminobenzyl(dimethyl)gallium
2-Dimethylaminophenylmethyl(dimethyl)gallium
2-Dimethylaminophenylmethyl(dimethyl)indium
2-Diethylaminophenylmethyl(dimethyl)gallium
2-Dimethylaminophenylmethyl(dimethyl)aluminium

2-Dimethylaminocyclohexylmethyl(dimethyl)gallium
2-Dipropylaminocyclohexylmethyl(dimethyl)aluminium
2-Dimethylaminomethylcyclohexyl(dimethyl)indium
Neu sind auch die Verbindungen der Formel III:

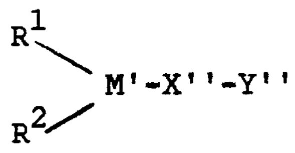

III

worin

| | |
|---|---|
| M' | Gallium oder Indium, |
| X'' | $-(CHR^5)_n$ mit n = 2, 3, 4 oder 5, |
| $R^5$ | jeweils H oder eine Alkylgruppe mit 1-4 C-Atomen, |
| Y'' | ein 5- oder 6-gliedriger heterocyclischer Ring, wobei das (die) Heteroatom(e) aus der 5. Hauptgruppe stammen oder $-NR^3R^4$, $-PR^3R^4$, $-AsR^3R^4$, $-SbR^3R^4$, und |
| $R^1$, $R^2$, $R^3$, $R^4$ | jeweils unabhängig voneinander H, eine geradkettige oder verzweigte Alkylgruppe mit 1-8 C-Atomen, die teilweise oder vollständig fluoriert sein kann, eine Cycloalkyl-, Alkenyl- oder Cycloalkenylgruppe mit jeweils 3-8 C-Atomen oder eine unsubstituierte oder substituierte Phenylgruppe bedeuten. |

n in X" bedeutet dabei bevorzugt 3 oder 4. Y" ist vorzugsweise $-NR^3R^4$, aber auch $-PR^3R^4$ oder $-AsR^3R^4$. Falls Y" ein Heterocyclus mit Atom(en) der 5. Hauptgruppe ist, so kommen Ringe mit N, P oder As, vorzugsweise aber die in Formel I für Y angegebenen Ringe (1) bis (5) in Frage. Für $R^1$-$R^4$ gelten die für Formel I angegebenen Bedeutungen.

Eine Reihe von Verbindungen werden im folgenden als beispielhafte Vertreter aufgefuhrt:
(3-Dimethylaminopropyl)dimethylgallium
(3-Dime hylaminopropyl)dimethylindium
(3-Diethylaminopropyl )dimethylgallium
(3-Diethylaminopropyl)dimethylindium
(3-Diethy aminopropyl)diethylindium
(4-Diethylaminobutyl)dime thylgallium
(4-Diisopropylaminobutyl)dimethylindium
[2-(2-Pyrid l)ethyl]dimethylindium
(4-N-Methyl-N-isopropylamino butyl)diethylgallium
(4-Dimethylaminobutyl)diisopropylgallium
( -Dipropylaminopropyl)diethylgallium
(3-N-Propyl-N-i sopropylaminopropyl)diisobutylindium
(4-Dimethylaminobutyl)diethyli dium
(4-Diethylaminobutyl)diethylgallium

Die Verbindungen der Formeln I, II und III, sind hervorragend für die MOCVD-Epitaxie bzw. MOCVD-Methode geeignet, da sie sich bei höheren Temperaturen unter Freisetzung des entsprechenden Metalles zersetzen. Sie sind ebenfalls für die anderen Methoden der Gasphasenabscheidung wie Photo-MOVP, Laser CVD oder MOMS geeignet.

Die Verbindungen der Formeln I, II und III werden nach an sich bekannten Methoden hergestellt, wie sie in der Literatur (z.B. G. Bähr, P. Burba, Methoden der Organischen Chemie, Bd. XIII/4, Georg Thieme Verlag, Stuttgart (1970)) beschrieben sind, und zwar unter Reaktionsbedinqungen, die für die genannten Umsetzungen bekannt und geeignet sind. Dabei kann man auch von an sich bekannten, hier nicht erwähnten Varianten Gebrauch machen.

Der Fachmann kann durch Routinemethoden entsprechende Synthesemethoden aus dem Stand der Technik entnehmen (z.B. US 3 154 528 oder Organometallics 1982, 1, 1492, Jastrzebski et al. oder Chem. Ber. 88, 251, 1765 (1955), Müller).

So können Verbindungen der Formeln I, II und III z.B. hergestellt werden, indem man Metallalkylchloride mit einem Alkalimetallorganyl der entsprechenden Lewisbase oder einer Grignard-Verbindung in einem inerten Lösungsmittel umsetzt.

Die Umsetzungen erfolgen vorzugsweise in inerten Lösungsmitteln. Als Lösungsmittel kommen dabei alle diejenigen in Frage, die die Umsetzung nicht stören und nicht in das Reaktionsgeschehen eingreifen. Die Reaktionstemperaturen entsprechen im wesentlichen denen, die aus der Literatur für die Herstellung ähnlicher Verbindungen bekannt sind.

Beim erfindungsgemäßen Verfahren zur Herstellung dünner Filme oder epitaktischer Schichten auf beliebigen Substraten setzt man bei den an sich bekannten Gasphasenabscheidungs-Prozessen von metallorganischen Verbindungen als Ausgangsverbindungen die intramolekular stabilisierten, metallorganischen Verbindungen der Formeln I, II und III ein.

Zur Herstellung von Verbindungshalbleitern werden beim erfindungsgemäßen Verfahren während des Abscheidungsprozesses in der Zersetzungskammer eine oder mehrere unter den angewandten Reaktionsbedingungen gasförmige Verbindungen des Arsens, Antimons oder Phosphors zugesetzt.

Die nach den erfindungsgemäßen Verfahren hergestellten Schichten können verwendet werden für die Herstellung von elektronischen und optoelektronischen Schaltelementen, Verbindungshalbleitern oder Lasern.

Die folgenden Beispiele sollen die Erfindung näher erläutern. Temperaturangaben erfolgen immer in Grad Celsius. Fp. bedeutet Schmelzpunkt und Kp. Siedepunkt.

A: Hers tellung der metallorganischen Verbindungen:

Beispiel 1

12 g (89 mmol) Dimethylgalliumchlorid werden in 300 ml Pentan vorgelegt und auf -78° abgekühlt. Dazu werden 8,3 g (89 mmol) Dimethylaminopropyllithium als Feststoff zugegeben. Man läßt die Lösung auf Raumtemperatur kommen und rührt noch 24 Stunden. Das ausgefallene Lithiumchlorid wird abgetrennt, das Lösungsmittel entfernt und der Rückstand im Vakuum destilliert. Man erhält Dimethylaminopropyl-(dimethyl)gallium als weißen Feststoff mit Kp. 65°/10 mbar.

Beispiel 2

Zu einer Lösung von 4 g (30 mmol) Dimethylgalliumchlorid in 50 ml Pentan werden bei -78° 3,6 g (30 mmol) Diethylaminopropyllithium, gelöst in 100 ml Pentan, gegeben. Man läßt die Lösung auf Raumtemperatur kommen und rührt noch 24 Stunden. Die Aufarbeitung erfolgt analog Beispiel 1. Anstelle der Destillation wird eine Sublimation durchgeführt. Man erhält Diethylaminopropyl(dimethyl)gallium mit Fp. 43-45°.

Beispiel 3

Zu einer Lösung von 4 g (30 mmol) Dimethylgalliumchlorid in 150 ml Pentan gibt man bei -78° 4,3 g (30 mmol) o-Lithium-N,N-dimethylbenzylamin. Die Aufarbeitung erfolgt analog Beispiel 1 mit Sublimation als Reinigungsschritt. Man erhält 1,2-Dimethylaminobenzyl(dimethyl)gallium mit Fp. 29-31°.

Beispiel 4

Analog Beispiel 1 erhält man aus Dimethylaluminiumchlorid und Dimethylaminopropyllithium Dimethylaminopropyl(dimethyl)aluminium mit Fp. 52°.

B: Anwendung zur Herstellung dünner Filme

Beispiel 1

Dimethylaminopropyl(dimethyl)gallium (dargestellt nach Beispiel 1) wird in den bubbler gefüllt und mit der Gaszufuhr des inerten Gases und der Zersetzungskammer verbunden. Abhängig vom Partialdampfdruck des Reagenz im Reaktor erfolgt eine Zersetzung unter Galliumabscheidung bei Temperaturen von ca. 700 °C.

Beispiel 2

Diethylaminopropyl(dimethyl)indium (herstellbar analog Beispiel 1) wird in den "bubbler" gefüllt, mit

Hilfe des Trägergases in den Dampfzustand gebracht und in die Zersetzungskammer transportiert. Zusätzlich wird in die Zersetzungskammer ein Phosphin eingeleitet. Bei einer Temperatur von ca. 650° in der Zersetzungskammer zersetzen sich die gasförmigen Substanzen und scheiden sich als InP-Überzug auf dem Substrat ab.

## Patentansprüche

**1.** Verwendung von metallorganischen Verbindungen der Formel I

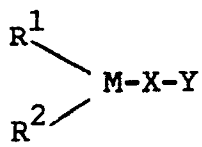

I

worin

| | |
|---|---|
| M | Aluminium, Indium, Gallium, |
| X | $-(CHR^5)_n-$ mit n = 2, 3, 4 oder 5, $-2-C_6H_4-(CH_2)_m-$, $-(CH_2)_m-2-C_6H_4-$, $-2-C_6H_{10}-(CH_2)_m-$, $-(CH_2)_m-2-C_6H_{10}-$ mit m = 1 oder 2, |
| $R^5$ | jeweils H oder eine Alkylgruppe mit 1-4 C-Atomen, |
| Y | ein 5- oder 6-gliedriger heterocyclischer Ring, wobei das (die) Heteroatom(e) aus der 5. Hauptgruppe stammen oder $-NR^3R^4$, $-PR^3R^4$, $-AsR^3R^4$, $-SbR^3R^4$, und |
| $R^1$, $R^2$, $R^3$, $R^4$ | jeweils unabhängig voneinander H, eine geradkettige oder verzweigte Alkylgruppe mit 1-8 C-Atomen, die teilweise oder vollständig fluoriert sein kann, eine Cycloalkyl-, Alkenyl- oder Cycloalkenylgruppe mit jeweils 3-8 C-Atomen oder eine unsubstituierte oder substituierte Phenylgruppe bedeuten, |

zur Gasphasenabscheidung des Metalls auf Substraten.

**2.** Verwendung der metallorganischen Verbindungen nach Anspruch 1, zur Abscheidung epitaktischer Schichten.

**3.** Verfahren zur Herstellung dünner Filme auf Substraten durch Gasphasenabscheidung des Metalls aus metallorganischen Verbindungen, dadurch gekennzeichnet, daß als metallorganische Verbindungen die Verbindungen der Formel I

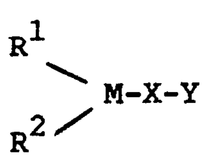

I

worin $R^1$, $R^2$, M, X und Y die in Anspruch 1 angegebenen Bedeutungen haben, eingesetzt werden.

**4.** Verfahren nach Anspruch 3, dadurch gekennzeichnet, daß man zur Herstellung von Verbindungshalbleitern während des Abscheidungsprozesses eine oder mehrere unter den angewandten Reaktionsbedingungen gasförmige Verbindungen des Arsens, Antimons oder Phosphors zuführt.

## Claims

**1.** Use of organometallic compounds of the formula I

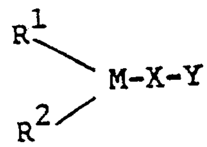

I

wherein

| | |
|---|---|
| M | denotes aluminium, indium or gallium, |
| X | denotes $-(CHR^5)_n-$ where n = 2, 3, 4 or 5, $-2-C_6H_4-(CH_2)_m-$, $-(CH_2)_m-2-C_6H_4-$,$-2-C_6H_{10}-(CH_2)_m-$, $-(CH_2)_m-2-C_6H_{10}-$where m = 1 or 2, |
| $R^5$ | in each case denotes H or an alkyl group containing 1-4 carbon atoms, |
| Y | denotes a 5- or 6-membered heterocycic ring, the heteroatom(s) originating from the 5th main group, or $-NR^3R^4$, $-PR^3R^4$, $-AsR^3R^4$ or $-SbR^3R^4$, and |
| $R^1$, $R^2$, $R^3$, $R^4$ | in each case denote, independently of each other, H, a straight-chain or branched alkyl group containing 1-8 carbon atoms, which may be partially or completely fluorinated, a cycloalkyl, alkenyl or cycloalkenyl group containing in each case 3-8 carbon atoms or an unsubstituted or substituted phenyl group, |

for gas-phase deposition of the metal on substrates.

2. Use of organometallic compounds according to claim 1, for depositing epitaxial layers.
an unsubstituted or substituted phenyl group,

3. Method for the production of thin films on substrates by gas-phase deposition of the metal from organometallic compounds, characterized in that, as organometallic compounds, use is made of the compounds of the formula I

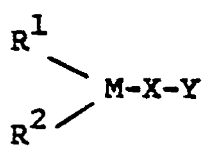

I

wherein $R^1$, $R^2$, M, X and Y have the meanings specified in claim 1.

4. Method according to claim 3, characterized in that, to produce compound semiconductors, one or more compounds of arsenic, antimony or phosphorus which are gaseous under the reaction conditions employed, are supplied during the deposition process.

**Revendications**

1. Utilisation de composés organométalliques de formule I

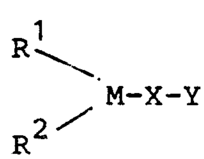

I

dans laquelle

| | |
|---|---|
| M | est l'aluminium, l'indium, le gallium, |
| X | est $-(CHR^5)_n-$ avec n = 2, 3, 4 ou 5, $-2-C_6H_4-(CH_2)_m-$, $-(CH_2)m-2-C_6H_4-$, $-2-C_6H_{10}-$ |

$(CH_2)_m$-, $-(CH_2)_m-2-C_6H_{10}$-avec m = 1 ou 2,

$R^5$ est soit H, soit un groupe alkyle avec 1-4 atomes de carbone,

Y est un hétérocycle à 5 ou 6 membres, le(s) hétéroatome(s) provenant du 5ème groupe ou $-NR^3R^4$, $-PR^3R^4$, $-AsR^3R^4$, $-SbR^3R^4$,

et

$R^1$, $R^2$, $R^3$, $R^4$ représentent, indépendamment l'un de l'autre, H, un groupe alkyle à chaîne droite ou ramifiée avec 1-8 atomes de carbone, qu'on peut fluorer partiellement ou totalement, un cycloalkyle, un groupe alcényle ou cycloalcényle avec 3-8 atomes de carbone chacun ou un groupe phényle substitué ou non,

pour déposer le métal sur des substrats à partir de phase gazeuse.

**2.** Utilisation de composés organométalliques selon la revendication 1, pour déposer des couches épitactiques.

**3.** Procédé de préparation de films minces sur des substrats par séparation à partir de phase gazeuse du métal de composes organométalliques, caractérisé en ce qu'on utilise comme composés organométalliques les composés de formule I

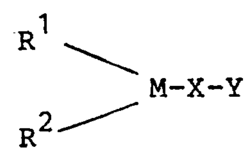

I

dans laquelle $R^1$, $R^2$, M, X et Y ont les significations données à la revendication 1.

**4.** Procédé selon la revendication 3, caractérisé en ce que pour réaliser des semi-conducteurs pendant le processus de dépôt on introduit un ou plusieurs composés d'arsenic, d'antimoine ou de phosphore gazeux dans les conditions de réaction utilisées.